# EUROPEAN PATENT APPLICATION

(11) **EP 4 361 314 A1**
(43) Date of publication of application: **01.05.2024**
(21) Application number: 23202124.6
(22) Date of filing: 06.10.2023
(51) Int. Cl.: C23C 28/02, C23C 28/00, F01D 5/00, F01D 5/28

(54) **COATING SYSTEM FOR COMPONENTS IN NEED OF REPAIR**

(30) Priority: 24.10.2022 US 202217971898
(71) Applicant: General Electric Company, Schenectady, NY 12345 (US)
(72) Inventor: NAGARAJ, Bangalore Aswatha, West Chester, 45069 (US); ZHANG, Liming, Greenville, 29615 (US)
(74) Representative: Openshaw & Co.

(57) **Abstract**

Methods of forming a coating system (18) on a surface (13) of a cobalt-based superalloy component (5) are provided. The method includes forming a nickel-based primer layer (20) on the surface (13) of the cobalt-based superalloy component (5); forming an intermediate nickel-containing layer (30) on the nickel-based primer layer (20), wherein the intermediate nickel-containing layer (30) comprises a nickel, chromium, and aluminum; forming an aluminide layer (34) on the intermediate nickel-containing layer (30); and heat treating the cobalt-based superalloy component (5) to form a diffusion coating (40) on the surface (13) of the cobalt-based superalloy component (5). Coated cobalt-based superalloy component (5)s formed from such a method are also provided.

## Description

### FIELD

Particular embodiments generally relate to protective coatings on components, and, more particularly, to coating systems that include a diffusion coating on gas turbine components having airfoils.

### BACKGROUND

In gas turbine engines, air is drawn into the front of the engine, compressed by a shaft-mounted compressor, and mixed with fuel. The mixture is combusted, and the resulting hot combustion gases are passed through a turbine mounted on the same shaft. The flow of gas turns the turbine by contacting an airfoil portion of the turbine blade, which turns the shaft and provides power to the compressor. The hotter the turbine gases, the more efficient the operation of the engine. Thus, there is an incentive to raise the turbine operating temperature. However, the maximum temperature of the turbine gases is normally limited by the materials used to fabricate the turbine vanes and turbine blades of the turbine.

### BRIEF DESCRIPTION OF THE DRAWINGS

A full and enabling disclosure of the present disclosure, including the best mode thereof, directed to one of ordinary skill in the art, is set forth in the specification, which makes reference to the appended figures, in which:
FIG. 1A is a perspective view of a component, in the form of a turbine blade of a gas turbine engine;
FIG. 1B is a perspective view of another component, in the form of a nozzle segment of a gas turbine engine;
FIG. 2 is a cross-sectional view of an exemplary coating system on a surface of a component, such as the airfoil of FIG. 1A or FIG. 1B, prior to heat treatment;
FIG. 3 is a cross-sectional view of an exemplary coating system including a MCrAlY coating after heat treatment and forming a TBC; and
FIG. 4 is a block diagram of an exemplary method of repairing a coating on a surface of an airfoil.

Repeat use of reference characters in the present specification and drawings is intended to represent the same or analogous features or elements of the present disclosure.

### DETAILED DESCRIPTION

Reference will now be made in detail to present embodiments of the disclosure, one or more examples of which are illustrated in the accompanying drawings. The detailed description uses numerical and letter designations to refer to features in the drawings. Like or similar designations in the drawings and description have been used to refer to like or similar parts of the disclosure.

The word "exemplary" is used herein to mean "serving as an example, instance, or illustration." Any implementation described herein as "exemplary" is not necessarily to be construed as preferred or advantageous over other implementations. Additionally, unless specifically identified otherwise, all embodiments described herein should be considered exemplary.

The singular forms "a", "an", and "the" include plural references unless the context clearly dictates otherwise. The term "at least one of" in the context of, e.g., "at least one of A, B, and C" refers to only A, only B, only C, or any combination of A, B, and C.

Here and throughout the specification and claims, range limitations are combined and interchanged, such ranges are identified and include all the sub-ranges contained therein unless context or language indicates otherwise. For example, all ranges disclosed herein are inclusive of the endpoints, and the endpoints are independently combinable with each other.

In the present disclosure, when a layer is being described as "on" or "over" another layer or substrate, it is to be understood that the layers can either be directly contacting each other or have another layer or feature between the layers, unless expressly stated to the contrary. Thus, these terms are simply describing the relative position of the layers to each other and do not necessarily mean "on top of" since the relative position above or below depends upon the orientation of the device to the viewer.

As used herein, the term "coating" refers to a material disposed on at least a portion of an underlying surface in a continuous or discontinuous manner. Further, the term "coating" does not necessarily mean a uniform thickness of the disposed material, and the disposed material may have a uniform or a variable thickness. The term "coating" may refer to a single layer of the coating material or may refer to a plurality of layers of the coating material. The coating material may be the same or different in the plurality of layers.

Chemical elements are discussed in the present disclosure using their common chemical abbreviation, such as commonly found on a periodic table of elements. For example, hydrogen is represented by its common chemical abbreviation H; helium is represented by its common chemical abbreviation He; and so forth.

A protective layer is applied to the airfoil of the turbine blade or turbine vane component, which acts as a substrate. The protective layer protects the substrate against environmental damage from the hot, highly corrosive combustion gases. For example, turbine airfoils may be manufactured with a cobalt-based superalloy coated with thermally sprayed MCrAlX (with M being Ni, Co, or a combination thereof; and with X being Hf or Y) coating. Cooling holes are drilled into the component after the coating is formed.

During repair of coated components, any previous coating remaining on the component is stripped (i.e., removed), but recoating of thermal sprayed thick coating will close the cooling holes. Instead, the state-of-the-art repair coating is a diffusion coating such as platinum aluminide, which is relatively thin, typically 1.5 mils (38.1 µm) to 3.5 mils (88.9 µm) thick. However, the environmental protection provided by such a thin platinum aluminide falls short of the original thick thermal sprayed coating. This deficiency in performance of repaired coating is exacerbated for cobalt-based superalloy components, since the platinum aluminide diffusion coating on a cobalt-based alloy provides inferior performance compared to that on nickel-based components.

Coating systems and methods are generally provided for cobalt-based superalloy components suitable for use as hot gas path components (e.g., airfoils) of turbine engines. The coating system is particularly suitable for use as a repair coating that may provide enhanced corrosion and oxidation resistance after the repair. Generally, the coating system has a multiple diffusion layer construction chemistry, which includes at least a nickel-based primer layer, an intermediate nickel-containing layer, and an aluminide layer (e.g., a platinum aluminide layer). These layers may be heat treated to form a diffusion coating on the surface of the cobalt-based superalloy component.

Without wishing to be bound by any particular theory, it is believed that diffusion of cobalt from the base alloy through a cobalt aluminide layer plays a key role in the aluminide coating process of cobalt-based alloys. The diffusion rate of cobalt through the cobalt aluminide layer is extremely slow (relative to the diffusion rate of nickel through a corresponding nickel aluminide layer). Thus, it is believed that this slow diffusion rate is a limiting factor in depositing a cobalt aluminide coating of adequate thickness on cobalt-based alloys. The present disclosure provides methods for forming a diffusion coating (including an aluminide) on the surface of the cobalt-based superalloy component despite the relatively slow diffusion rate of cobalt.

In particular embodiments, the diffusion coating can reduce the susceptibility of gas turbine components to property degradation such as low-cycle fatigue failures, while retaining the benefits associated with protective coatings that are applied to the components. The present approach may be accomplished as part of the normal repair operation or maintenance operation, without major modifications.

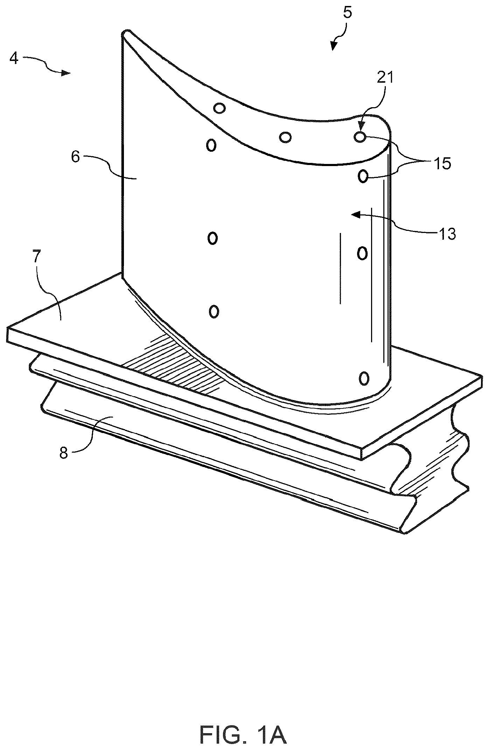

Referring to the drawings, FIG. 1A depicts an exemplary component 5 of a gas turbine engine, illustrated as a gas turbine blade 4. The component 5 (shown as a turbine blade 4) includes an airfoil 6, a laterally extending platform 7, an attachment 8 in the form of a dovetail to attach the component 5 (shown as a turbine blade 4) to a turbine disk (not shown). The component 5 has an exposed, stripped surface 13 in need of repair. The stripped surface 13 may be exposed on the component 5 after removal of any prior coatings thereon, which may have been in need of repair due to on degradation from operational use, damage from operational use (e.g., an impact or rub event), a defect in the original coating, or another event that exposes the surface 13. In some components, a number of internal passages 21 (e.g., cooling channels) extend through the interior of the airfoil 6, ending in openings 15 in the surface 13 of the airfoil 6. The openings 15 may be, in particular embodiments, film holes that are in fluid communication with a cooling fluid via the internal passages 21.

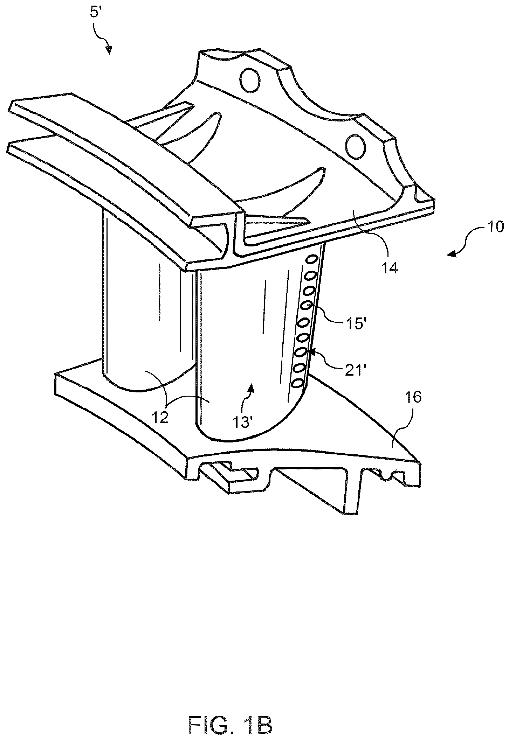

FIG. 1B represents an additional exemplary component 5' in the form of a nozzle segment 10 that may be utilized as one of a number of nozzle segments that, when connected together, form an annular-shaped nozzle assembly of a gas turbine engine. As in FIG. 1A, the component 5' shown in FIG. 1B has an exposed surface 13' in need of repair. The segment 10 is made up of multiple vanes 12, each defining an airfoil and extending between outer and inner platforms 14 and 16. The vanes 12 and platforms 14 and 16 can be formed separately and then assembled, such as by brazing the ends of each vane 12 within openings defined in the platforms 14 and 16. Alternatively, the entire segment 10 can be formed as an integral casting. The vanes 12 generally have a leading edge, a trailing edge, a pressure side (i.e., the concave side), and a suction side (i.e., the convex side). The leading edge is at times described as being defined by the most forward point (nose) of the vane 12.

When the nozzle segment 10 is assembled with other nozzle segments to form a nozzle assembly, the respective inner and outer platforms of the segments form continuous inner and outer bands between which the vanes 12 are circumferentially spaced and radially extend. Construction of a nozzle assembly with individual nozzle segments 10 is often expedient due to the complexities of the cooling schemes typically employed. The nozzle segment 10 depicted in FIG. 1B is termed a doublet because two vanes 12 are associated with each segment 10. Nozzle segments 10 can be equipped with more than two vanes 12, e.g., three vanes (termed a triplet), four vanes, six vanes, or with a single vane to form what is termed a singlet. As known in the art, the design choice between singlet and doublet castings takes into consideration the advantages associated with their different constructions and processing. A significant advantage of singlet nozzle construction is the capability for excellent coating thickness distribution around the vanes 12, which in addition to promoting oxidation and corrosion resistance also promotes control of the throat area between nozzles and uniformity between vanes of different stages. On the other hand, a doublet casting avoids the necessity for a high temperature braze operation, though with less control of coating thickness.

Similar to FIG. 1A, a number of internal passages 21 (e.g., cooling channels) extend through the interior of the vanes 12 of FIG. 1B, ending in openings 15' in the surface 13' of the vanes 12. The openings 15' may be, in particular embodiments, film holes in fluid communication with a cooling fluid via the internal passages 21.

In one embodiment, the airfoil 6 of the turbine blade 4 of FIG. 1A and the vanes 12 of the nozzle segment 10 of FIG. 1B are located in the turbine section of the engine and are subjected to the hot combustion gases from the engine's combustor. In addition to forced air cooling techniques (e.g., via film holes 15), it is desired to protect the surfaces 13 of these components 5 via a coating system, as discussed below in greater detail.

The airfoil 6 of the component 5 (shown as a turbine blade 4) of FIG. 1A and the vanes 12 of the nozzle segment 10 of FIG. 1B is formed of a cobalt-based superalloy that can be formed to the desired shape and withstand the necessary operating loads at the intended operating temperatures of the area of the gas turbine in which the segment will be installed. In typical embodiments, the cobalt-based superalloy component has a 2-phase structure of fine γ-(M) (face-center cubic) and β-(M)Al (body-center cubic). The β-(M)Al phase is the aluminum (Al) reservoir. For example, turbine airfoils 6 or vanes 12 may be originally manufactured from a cobalt-based superalloy with a thermally sprayed coating of aluminum-based coating having an original thickness of 125 µm to 385 µm. Aluminum near the surface may be depleted during service by diffusion to the TBC interface forming α-Al₂O₃ thermally grown oxide on the surface of the diffusion coated substrate. Thus, after use, the cobalt-based superalloy component may have an aluminum deficiency, which can be exposed after degradation or removal of the overlying TBC.

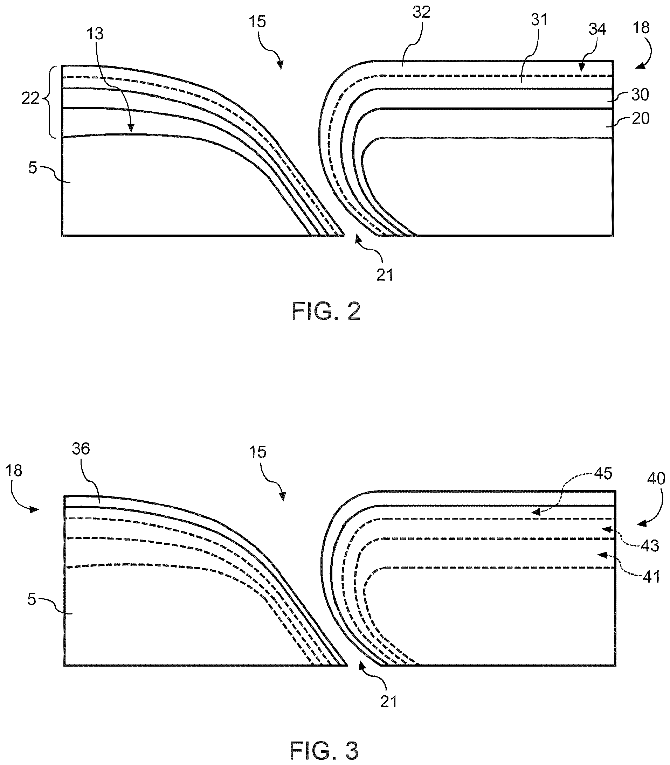

Although described above and in FIGS. 1A and 1B with respect to the component 5 (e.g., the turbine blade 4 and the nozzle segment 10), the following repair coating system 18 (FIG. 2) can be utilized with any component of the gas turbine engine that is in need of repair. As described above, the stripped surface 13 may be exposed on the component 5 after removal of any prior coatings thereon, which may be removed by any suitable method, including but not limited to mechanical methods (e.g., grinding), chemical methods (e.g., chemical etching), or combinations thereof. The component 5 may have been in need of repair due to on degradation from operational use, damage from operational use (e.g., an impact or rub event), a defect in the original coating, or another event that exposes the surface 13..

Referring to FIG. 2, an exemplary coating system 18 is shown including a plurality of layers 22 prior to heat treatment. In the embodiment shown, a nickel-based primer layer 20 is shown on the surface 13 of the cobalt-based superalloy component 5. An intermediate nickel-containing layer 30 is on the nickel-based primer layer 20. Finally, an aluminide layer 34 (e.g., a platinum aluminide layer) is on the intermediate nickel-containing layer 30. Each of these layers is discussed in greater detail below. It is noted that the layers shown are not depicted in relative thickness. For example, the nickel-based primer layer 20 may be deposited to a thickness that is significantly less than the intermediate nickel-containing layer 30. For example, the nickel-based primer layer 20 may be deposited to a thickness that is less than 25% of a thickness of the intermediate nickel-containing layer 30, such as less than 10%.

During deposition of the plurality of layers 22, each of the plurality of layers 22 may be deposited within the internal passages 21 of the openings 15 while keeping the internal passages 21 open for fluid flow therethrough. That is, each of the nickel-based primer layer 20, the intermediate nickel-containing layer 30, and the aluminide layer 34 may be formed on internal surfaces 13 within the internal passages 21 of the cooling holes 15 in a manner that keeps the passages open for fluid flow therethrough.

The nickel-based primer layer 20 may be formed, in particular embodiments, directly on the surface 13 of the cobalt-based superalloy component 5. The nickel-based primer layer 20 may be formed from elemental nickel, such as through nickel plating the elemental Ni onto the surface 13 of the superalloy component 5. The nickel-based primer layer 20 generally serves as a bonding layer to increase the affinity between the cobalt-based superalloy component 5 and the overlying intermediate nickel-containing layer 30.

The nickel-based primer layer 20 may be formed to a relatively thin layer sufficient to increase the bonding of the overlying layers while remaining thin enough so as to not increase the overall thickness of the resulting diffusion coatings to avoid closing the film holes within the surface 13. For example, the nickel-based primer layer 20 may have a thickness of 12.5 µm to 25 µm. The cooling holes 15 remain open after application of the nickel-based primer layer 20.

As stated, an intermediate nickel-containing layer 30 may be formed on the nickel-based primer layer 20. In particular embodiments, the intermediate nickel-containing layer 30 is formed directly on the nickel-based primer layer 20. In particular embodiments, the intermediate nickel-containing layer 30 may include Cr, Co, Al, and Ni.

In one embodiment, the intermediate nickel-containing layer 30 may be deposited with a composition, prior to forming the platinum-group metal layer, has a composition comprising, by weight, up to 25% Cr (e.g., 10% to 25% Cr), 6 to 7% Al, up to 1% Hf (e.g., 0.1% to 1% Hf), up to 0.5% Y (e.g., 0.1% to 0.5% Y), 8 to 12% Co, 5 to 7% Ta, 1 to 3% Re, 0.5 to 1.5% Si, up to 0.5% Zr (e.g., 0.0001% to 0.5% Zr), and the balance Ni. In certain embodiments, the MCrAlY layer includes strengthening components (e.g., Re, Ta, Hf, Zr, Si, or a mixture thereof) within its composition. For example, the as-deposited MCrAlY layer (e.g., prior to Pt plating and Al deposition) may include 5% to 7% Ta, 1% to 3% Re, by weight, or both. For example, the intermediate nickel-containing layer comprises MCrAlX where M is Ni with Co optionally present and where X is Hf, Y, Zr, or combinations thereof (e.g., NiCoCrAlY, NiCrAlY, etc., or combinations thereof). In another embodiment, the intermediate nickel-containing layer comprises NiAl(CrZr).

The intermediate nickel-containing layer 30 is formed on the surface 13 of the component 5 thereby according to any suitable application process. Non-limiting examples include plasma deposition (for example, ion plasma deposition, vacuum plasma spraying (VPS), low pressure plasma spray (LPPS), and plasma-enhanced chemical-vapor deposition (PECVD)), high velocity oxygen fuel (HVOF) techniques, high-velocity air-fuel (HVAF) techniques, physical vapor deposition (PVD), electron beam physical vapor deposition (EBPVD), chemical vapor deposition (CVD), air plasma spray (APS), cold spraying, and laser ablation. In one embodiment, the intermediate nickel-containing layer 30 is applied by a thermal spray technique (for example, VPS, LPPS, HVOF, HVAF, APS, cold-spraying, etc.). In one particular embodiment, the intermediate nickel-containing layer 30 is formed via ion plasma deposition.

The intermediate nickel-containing layer 30 may formed to a thickness on the surface 13 of 25 µm to 130 µm (e.g., 25 µm to 100 µm). By keeping the intermediate nickel-containing layer 30 relatively thin. It will be understood that any openings 15 (e.g., film holes) defined within the surface 13 can remain open even without the use of mask or other deposition blocking method.

The aluminide layer 34 may then be formed on the intermediate nickel-containing layer 30 to further promote oxidation resistance. In one particular embodiment, the aluminide layer 34 may include aluminum intermetallics, gamma phase, gamma prime phase, or the like, which may be formed to by any suitable method. For example, the aluminide layer 34 can be deposited by any operable approach, such as aluminiding by pack cementation, or other processes including vapor phase aluminiding.

In one embodiment, the aluminide layer 34 is deposited via vapor phase aluminiding. For example, a hydrogen halide gas, such as hydrogen chloride or hydrogen fluoride, is contacted with aluminum metal or an aluminum alloy to form the corresponding aluminum halide gas. Other elements may be doped into the aluminide layer 34 from a corresponding gas, if desired. The deposition occurs at elevated temperature such as from 900 °C to 1065 °C during a cycle time (e.g., a 4 to 20 hour cycle). However, these deposition temperatures are slightly lower for Co-based substrates compared to other superalloys, which is unexpected due to the relatively slow diffusion rate of cobalt. The aluminide layer 34 is preferably from 12 to 125 micrometers thick (such as 25 µm to 100 µm, for example 35 µm to 75 µm). The deposition technique allows alloying elements to be co-deposited into the aluminide layer 34 if desired, from the halide gas.

When the aluminide layer 34 comprises platinum aluminide layer, the aluminide layer 34 may be formed, in particular embodiments, in a multilayer deposition process that includes forming a platinum-group metal layer 31 on the intermediate nickel-containing layer and then forming an aluminide coating 32 over the platinum-group metal layer 31.

In such an embodiment, the platinum-group metal layer 31 is deposited on the intermediate nickel-containing layer 30. The platinum-group metal layer 31 generally includes platinum, rhodium, palladium, ruthenium, osmium, iridium, or a mixture thereof. These elements have similar physical and chemical properties and tend to occur together in the same mineral deposits. In one embodiment, the palladium-group platinum-group metals (i.e., platinum, rhodium, palladium, or a mixture thereof) are included in the platinum-group metal layer 31. In one particular embodiment, the platinum-group metal layer 31 generally includes platinum, but may also include other elements (e.g., palladium, rhodium, or a combination thereof). For example, the platinum-group metal layer 31 can include a platinum-palladium alloy, a platinum-rhodium alloy, or a platinum-palladium-rhodium alloy. In one embodiment, platinum-group metal layer 31 includes platinum in at least 50% by weight (e.g., 75% to 100% by weight).

In most embodiments, a suitable thickness for a platinum-group metal layer 31 is 1 µm to 10 µm (e.g., 3 µm to 7 µm). In the embodiment shown, the platinum-group metal layer 31 is formed directly on the intermediate nickel-containing layer 30 due to this relatively thin nature of the platinum-group metal layer 31.

The platinum-group metal layer 31 can be formed via any suitable process. For example, the platinum-group metal layer 31 is, in one particular embodiment, deposited by an electrodeposition process as (e.g., electroplating), although sputtering, brush plating, etc. could alternatively be used. Plating can be performed at room temperature (e.g., 20 °C to 25 °C). In one embodiment, the electrodeposition process is accomplished by placing a platinum-group metal-containing solution (e.g., platinum-containing solution) into a deposition tank and depositing platinum-group metal from the solution onto the intermediate nickel-containing layer. For example, when depositing platinum, the platinum-containing aqueous solution can include Pt(NH₃)₄ HPO₄, and the voltage/current source can be operated at 1/2-10 amperes per square foot of facing article surface.

Then, the aluminide coating 32 may be applied, in this embodiment, onto the platinum-group metal layer 31 to further promote the oxidation resistance. In one particular embodiment, the aluminide coating 32 may include aluminum intermetallics, gamma phase, gamma prime phase, or the like. The aluminide coating 32 is deposited overlying the platinum-group metal layer 31. The aluminide coating 32 can be formed to a thickness of 2 µm to 100 µm (e.g., 25 µm to 100 µm, such as 35 µm to 75 µm) by any suitable method. For example, the aluminide coating 32 can be deposited by any operable approach, such as aluminiding by pack cementation, or other processes including vapor phase aluminiding (as discussed above with respect to the aluminide layer 34). Because the deposition of aluminum is performed at elevated temperature, the deposited aluminum atoms interdiffuse with the platinum-group metal layer 31 (or interdiffused platinum/substrate region), with the material of the surface 13, or both to form a diffusion zone.

In the embodiment shown in FIG. 2, the aluminide coating 32 is deposited on the entire surface 13, within any cavities and any openings 15 (e.g., film holes) present in the surface 13, and over the platinum-group metal layer 31.

During processing, the aluminide coating 32 reacts with the platinum-group metal layer 31 to form an aluminide layer 34 that includes platinum aluminide. That is, the aluminide layer 34 that includes platinum aluminide comprises the platinum-group metal and aluminum, such as platinum-modified aluminides (PtAl), but may contain additional components (e.g., platinum-modified nickel aluminides). Thus, the platinum-group metal plating, followed by diffusion aluminide, results in a "aluminide layer 34 that includes platinum aluminide" where its outer layer of the coating has the platinum-group metal (e.g., platinum), in addition to diffusion aluminide.

Following formation of the nickel-based primer layer 20, the intermediate nickel-containing layer 30, and the aluminide layer 34 (e.g., platinum aluminide), the component may be heat treated to form a diffusion coating 40 (FIG. 3) on the surface 13 of the cobalt-based superalloy component 5. In one embodiment, heat treatment is performed in vacuum (e.g., at a treatment pressure of 10 torr or less, such as at a treatment pressure of 1 torr or less) at a treatment temperature of 900 °C to 1065 °C for a treatment period (e.g., for a treatment period of 1 to 4 hours). During this heat treatment, the materials of the component (e.g., cobalt) diffuse with the materials of the nickel-based primer layer 20, the intermediate nickel-containing layer 30, and the aluminide layer 34. As stated above, the diffusion of cobalt from the component 5 into the diffusion coating 40 plays a key role in the formation of the diffusion coating 40, even though the diffusion rate of cobalt is extremely slow through aluminide layer 34 (relative to the diffusion rate of nickel through a corresponding nickel aluminide layer).

As shown in FIG. 3, generally, the resulting coating system 18 has a compositional gradient throughout its thickness, and includes an inner portion 41, a middle portion 43, and an outer portion 45. A thermal barrier coating (TBC) 36 is optionally positioned on the coating system 18 on its surface opposite of the component 5. However, in particular embodiments (not shown), the coating system 18 is completely free from any TBC 36 on the surface of the outer portion 45 such that the outer portion 45 defines an external surface of the coated component 5.

The inner portion 41 generally corresponds to the nickel-based primer layer 20 and is the most inner diffusion layer to the component 5, while the outer portion 45 is opposite from the component and adjacent to the TBC 36, when a TBC is included. Each of the inner portion 41, the middle portion 43, and the outer portion 45 may generally define a certain thickness of the coating system 18. In certain embodiments, the inner portion 41 may have an inner thickness that is less than a middle thickness of the middle portion 43. In an embodiment, the diffusion coating 40 has a thickness of 60 µm to 100 µm (e.g., 75 µm to 85 µm).

The coating system 18, in one embodiment, has a compositional gradient with the outer portion 45 having a relatively low concentration of Ni and relatively high concentrations of Pt and Al, when compared to the composition of the middle portion 43. As such, outer portion 45 has good oxidation qualities and adherence to TBC (or other layers thereon). However, an increased concentration of Ni in the middle portion 43, the inner portion 41, or both can allow for increased corrosion resistance.

The coating system 18 is deposited and processed to have a smooth surface finish, e.g., 3 µm or less of surface roughness (Ra), in order to promote the aerodynamics of the component 5. In one embodiment, the coating system 18 preferably has a surface roughness (Ra) of less than 3 µm (e.g., 0.75 µm to 2.75 µm, such as 1.25 µm to 2.25 µm).

FIG. 3 also shows coating system 18 with the optional thermal barrier coating (TBC) 36 over the coating system 18, which is particularly useful if further protection is required (e.g., on the surface of a vane 12 to be used at very high temperatures). In particular embodiments, the TBC 36 may also be deposited on the surfaces of the inner bands and outer bands. For example, the TBC 36 may be entirely composed of one or more ceramic compositions. The TBC 36 may be applied by any operable technique, with electron beam physical vapor deposition (EB-PVD) being preferred for the preferred yttria-stabilized zirconia coating. The EB-PVD processing may be preceded or followed by high-temperature processes that may affect the distribution of elements in the bond coat. The EB-PVD process itself is typically conducted at elevated temperatures. Other coatings, coating compositions, and coating thicknesses are also within the scope of the disclosure.

The TBC 36 is deposited and processed to have a very smooth surface finish, e.g., 1.5 µm Ra or less, in order to promote the aerodynamics of the nozzle assembly. In one embodiment, the TBC 36 preferably has an as-deposited surface roughness (Ra) of less than 3 µm . Thereafter, the surface of the TBC 36 preferably undergoes processing, preferably peening and then tumbling, to improve the surface finish of the TBC 36. Following peening and tumbling, the TBC 36 preferably has a surface roughness of not higher than 2.0 µm Ra, with a typical range being 1.3 µm to 1.8 µm Ra on the concave surfaces and leading edges of the vanes, and 0.5 µm to 1.0 µm Ra on the convex surfaces of the vanes.

The present disclosure is particularly applicable to components that operate within environments characterized by relatively high temperatures, and particularly to components of the type represented in FIGS. 1A and 1B and therefore subjected to severe oxidizing and corrosive operating environments. It should be noted that the drawings are drawn for purposes of clarity when viewed in combination with the following description, and therefore are not intended to be to scale.

Methods are also generally provided for forming a coating on a surface of a component 5 (e.g., an airfoil) at repair of the component 5. For example, the method may be a multiple step process for forming a coating system, particularly suitable for repair of a coating system. In one embodiment, the recoating includes multiple steps, including: removing any existing coating on the surface; forming a nickel-based primer layer for a better adhesive for subsequent layers on the cobalt-based superalloy component; forming an intermediate nickel-containing layer (e.g., MCrAlX where M is Ni with Co optionally present and where X is Hf, Y, Zr, or a combination thereof); forming an aluminide layer (e.g., an aluminide layer that includes platinum aluminide) to provide improved resistance to corrosion and oxidation; and heat treating the layers to form a diffusion coating.

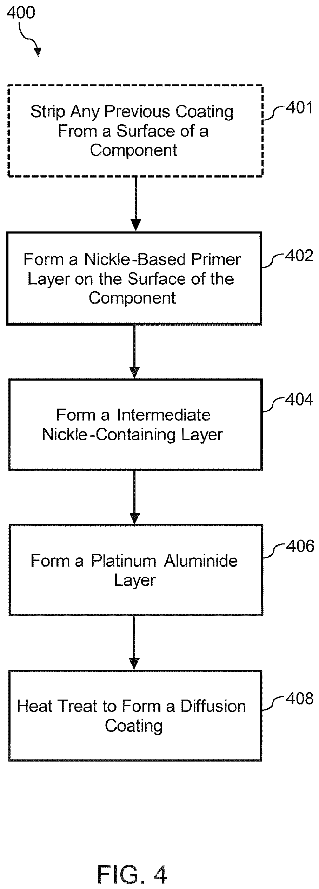

Referring to FIG. 4, a diagram of an exemplary method 400 is generally shown for forming a coating on a surface of a component in need of repair. At 401, any previous coating may be optionally stripped, if still present on the surface of the component. At 402, a nickel-based primer layer is deposited on the surface of a cobalt-based superalloy component, such as an electroplating process described above. At 404, an intermediate nickel-containing layer is deposited on the nickel-based primer layer. At 406, an aluminide layer is formed on the intermediate nickel-containing layer. The layers may then be heat treated at 408, such as via heating to a treatment temperature of 900 °C to 1200 °C as described above.

Further aspects are provided by the subject matter of the following clauses:

A method of forming a coating system on a surface of a cobalt-based superalloy component in need of repair, the method comprising: forming a nickel-based primer layer on the surface of the cobalt-based superalloy component; forming an intermediate nickel-containing layer on the nickel-based primer layer, wherein the intermediate nickel-containing layer comprises nickel, chromium, and aluminum; forming an aluminide layer on the intermediate nickel-containing layer; and heat treating the cobalt-based superalloy component to form a diffusion coating from the nickel-based primer layer, the intermediate nickel-containing layer, and the aluminide layer on the surface of the cobalt-based superalloy component.

The method of any preceding clause, wherein the heat treating is performed at a treatment temperature of 900 °C to 1200 °C.

The method of any preceding clause, wherein the nickel-based primer layer has a thickness of 12.5 µm to 25 µm.

The method of any preceding clause, wherein the nickel-based primer layer comprises elemental Ni.

The method of any preceding clause, wherein forming the nickel-based primer layer comprises nickel plating the elemental Ni onto the surface of the cobalt-based superalloy component.

The method of any preceding clause, wherein the intermediate nickel-containing layer comprises MCrAlX where M is Ni with Co optionally present and where X is Hf, Y, Zr, or a combination thereof.

The method of any preceding clause, wherein the intermediate nickel-containing layer comprises NiCoCrAlY, NiCrAlY, or a combination thereof.

The method of any preceding clause, wherein the intermediate nickel-containing layer comprises NiAl(CrZr).

The method of any preceding clause, wherein the intermediate nickel-containing layer has a thickness of 25 µm to 130 µm.

The method of any preceding clause, wherein the intermediate nickel-containing layer has a chromium content that is higher than the cobalt-based superalloy component.

The method of any preceding clause, wherein forming the aluminide layer on the intermediate nickel-containing layer comprises: forming a platinum-group metal layer on the intermediate nickel-containing layer; and forming an aluminide coating over the platinum-group metal layer such that the aluminide layer comprises platinum aluminide.

The method of any preceding clause, wherein forming the aluminide coating comprises vapor phase aluminiding with an aluminum halide.

The method of any preceding clause, wherein the aluminide coating is formed to a thickness of 25 µm to 100 µm.

The method of any preceding clause, wherein the surface of the cobalt-based superalloy component defines a plurality of openings, and wherein each opening of the plurality of openings remains open after forming the diffusion coating thereon.

The method of any preceding clause, wherein the surface extends into a plurality of internal passages, with each internal passage of the plurality of internal passages extending from a respective opening of the plurality of openings such that the diffusion coating is formed within the plurality of internal passages while keeping the plurality of internal passages open for fluid flow therethrough.

The method of claim 1, further comprising: after forming the diffusion coating, forming a thermal barrier coating on the diffusion coating.

The method of claim 1, further comprising: prior to forming the nickel-based primer layer, stripping a previous coating from the surface of the cobalt-based superalloy component.

A repaired component, comprising: a cobalt-based superalloy component having a surface; and a diffusion coating on the surface of the cobalt-based superalloy component, wherein the diffusion coating comprises an inner portion, an intermediate nickel-containing layer, and an aluminide layer.

The repaired component of any preceding clause, wherein the inner portion comprises elemental Ni.

The repaired component of any preceding clause, wherein the intermediate nickel-containing layer comprises MCrAlX where M is Ni with Co optionally present and where X is Hf, Y, Zr, or a combination thereof.

The repaired component of any preceding clause, wherein the aluminide layer comprises platinum aluminide, wherein the repaired is free of any thermal barrier coating on the diffusion coating.

A method of forming a coating system (18) on a surface (13) of a cobalt-based superalloy component (5), the method comprising:
forming a nickel-based primer layer (20) on the surface (13) of the cobalt-based superalloy component (5);
forming an intermediate nickel-containing layer (30) on the nickel-based primer layer (20), wherein the intermediate nickel-containing layer (30) comprises a nickel, chromium, and aluminum;
forming an aluminide layer (34) on the intermediate nickel-containing layer (30); and
heat treating the cobalt-based superalloy component (5) to form a diffusion coating (40) on the surface (13) of the cobalt-based superalloy component (5).

The method of any preceding clause, wherein heat treating the cobalt-based superalloy component (5) is performed at a treatment temperature of 900 °C to 1200 °C, and wherein the surface (13) of the cobalt-based superalloy component (5) defines a plurality of film holes therein that remain open after forming the diffusion coating (40) thereon.

The method of any preceding clause, wherein the nickel-based primer layer (20) has a thickness of 12.5 µm to 25 µm.

The method of any preceding clause, wherein the nickel-based primer layer (20) comprises elemental Ni, and wherein forming the nickel-based primer layer (20) comprises nickel plating the elemental Ni onto the surface (13) of the cobalt-based superalloy component (5).

The method of any preceding clause, wherein the intermediate nickel-containing layer (30) comprises MCrAlX where M is Ni with Co optionally present and where X is Hf, Y and/or Zr, wherein the intermediate nickel-containing layer (30) has a thickness of 25 µm to 130 µm.

The method of any preceding clause, wherein the intermediate nickel-containing layer (30) comprises NiCoCrAlY, NiCrAlY, or a combination thereof.

The method of any preceding clause, wherein the intermediate nickel-containing layer (30) comprises NiAl(CrZr).

The method of any preceding clause, wherein the intermediate nickel-containing layer (30) has a chromium content that is higher than the cobalt-based superalloy component (5).

The method of any preceding clause, wherein forming the aluminide layer (34) on the intermediate nickel-containing layer (30) comprises:
forming a platinum-group metal layer (31) on the intermediate nickel-containing layer (30);
forming an aluminide coating (32) over the platinum-group metal layer (31) such that the aluminide layer (34) comprises platinum aluminide.

The method of any preceding clause, wherein forming the aluminide coating (32) comprises vapor phase aluminiding with an aluminum halide, and wherein the aluminide coating (32) is formed to a thickness of 25 µm to 100 µm.

The method of any preceding clause, further comprising:
after forming the diffusion coating (40), forming a thermal barrier coating (36).

The method of any preceding clause, further comprising:
prior to forming the nickel-based primer layer (20), stripping a previous coating from the surface (13) of the cobalt-based superalloy component (5).

A coated cobalt-based superalloy component (5), comprising:
a cobalt-based superalloy component (5) having a surface (13); and
a diffusion coating (40) on the surface (13) of the cobalt-based superalloy component (5), wherein the diffusion coating (40) comprises an inner portion (41), an intermediate nickel-containing layer (30), and an aluminide layer (34).

The coated cobalt-based superalloy component (5) of any preceding clause, wherein the inner portion (41) comprises elemental Ni, and wherein the intermediate nickel-containing layer (30) comprises MCrAlX where M is Ni with Co optionally present and where X is Hf, Y and/or Zr.

The coated cobalt-based superalloy component (5) of any preceding clause, wherein the aluminide layer (34) comprises platinum aluminide, wherein the coated cobalt-based superalloy component (5) is free of any thermal barrier coating (36) on the diffusion coating (40).

This written description uses examples to disclose the present disclosure, including the best mode, and also to enable any person skilled in the art to practice the disclosure, including making and using any devices or systems and performing any incorporated methods. The patentable scope of the disclosure is defined by the claims, and may include other examples that occur to those skilled in the art. Such other examples are intended to be within the scope of the claims if they include structural elements that do not differ from the literal language of the claims, or if they include equivalent structural elements with insubstantial differences from the literal languages of the claims.

## Claims

1. A method of forming a coating system (18) on a surface (13) of a cobalt-based superalloy component (5), the method comprising:
forming a nickel-based primer layer (20) on the surface (13) of the cobalt-based superalloy component (5);
forming an intermediate nickel-containing layer (30) on the nickel-based primer layer (20), wherein the intermediate nickel-containing layer (30) comprises a nickel, chromium, and aluminum;
forming an aluminide layer (34) on the intermediate nickel-containing layer (30); and
heat treating the cobalt-based superalloy component (5) to form a diffusion coating (40) on the surface (13) of the cobalt-based superalloy component (5).

2. The method of any preceding claim, wherein heat treating the cobalt-based superalloy component (5) is performed at a treatment temperature of 900 °C to 1200 °C, and wherein the surface (13) of the cobalt-based superalloy component (5) defines a plurality of film holes therein that remain open after forming the diffusion coating (40) thereon.

3. The method of any preceding claim, wherein the nickel-based primer layer (20) has a thickness of 12.5 µm to 25 µm.

4. The method of any preceding claim, wherein the nickel-based primer layer (20) comprises elemental Ni, and wherein forming the nickel-based primer layer (20) comprises nickel plating the elemental Ni onto the surface (13) of the cobalt-based superalloy component (5).

5. The method of any preceding claim, wherein the intermediate nickel-containing layer (30) comprises MCrAlX where M is Ni with Co optionally present and where X is Hf, Y and/or Zr, wherein the intermediate nickel-containing layer (30) has a thickness of 25 µm to 130 µm.

6. The method of any preceding claim, wherein the intermediate nickel-containing layer (30) comprises NiCoCrAlY, NiCrAlY, or a combination thereof.

7. The method of any preceding claim, wherein the intermediate nickel-containing layer (30) comprises NiAl(CrZr).

8. The method of any preceding claim, wherein the intermediate nickel-containing layer (30) has a chromium content that is higher than the cobalt-based superalloy component (5).

9. The method of any preceding claim, wherein forming the aluminide layer (34) on the intermediate nickel-containing layer (30) comprises:
forming a platinum-group metal layer (31) on the intermediate nickel-containing layer (30);
forming an aluminide coating (32) over the platinum-group metal layer (31) such that the aluminide layer (34) comprises platinum aluminide.

10. The method of any preceding claim, wherein forming the aluminide coating (32) comprises vapor phase aluminiding with an aluminum halide, and wherein the aluminide coating (32) is formed to a thickness of 25 µm to 100 µm.

11. The method of any preceding claim, further comprising:
after forming the diffusion coating (40), forming a thermal barrier coating (36).

12. The method of any preceding claim, further comprising:
prior to forming the nickel-based primer layer (20), stripping a previous coating from the surface (13) of the cobalt-based superalloy component (5).

13. A coated cobalt-based superalloy component (5), comprising:
a cobalt-based superalloy component (5) having a surface (13); and
a diffusion coating (40) on the surface (13) of the cobalt-based superalloy component (5), wherein the diffusion coating (40) comprises an inner portion (41), an intermediate nickel-containing layer (30), and an aluminide layer (34).

14. The coated cobalt-based superalloy component (5) of any preceding claim, wherein the inner portion (41) comprises elemental Ni, and wherein the intermediate nickel-containing layer (30) comprises MCrAlX where M is Ni with Co optionally present and where X is Hf, Y and/or Zr.

15. The coated cobalt-based superalloy component (5) of any preceding claim, wherein the aluminide layer (34) comprises platinum aluminide, wherein the coated cobalt-based superalloy component (5) is free of any thermal barrier coating (36) on the diffusion coating (40).
